# DEMANDE DE BREVET EUROPEEN

(11) **EP 1 916 770 A1**
(43) Date de publication de la demande: **30.04.2008**
(21) Numéro de dépôt: 07117910.5
(22) Date de dépôt: 04.10.2007
(51) Int. Cl.: H03M 1/46

(54) **Convertisseur analogique/numérique à approximations successives, composant intégré et procédé de conversion correspondants**

(30) Priorité: 26.10.2006 FR 0609418
(71) Demandeur: ATMEL NANTES SA, 44306 Nantes Cédex 3 (FR)
(72) Inventeur: Chatal, Joël, 44470 Carquefou (FR); Bendraoui, Abdellatif, 44450 Saint Julien de Concelles (FR)
(74) Mandataire: Guéné, Patrick Lucien Juan Joseph

(57) **Abrégé**

L'invention concerne un convertisseur analogique / numérique à approximations successives (7000) comprenant un registre à approximations successives (730) alimentant un convertisseur numérique / analogique (710), des premier moyens de comparaison (720) d'un signal d'entrée (Vin; Vin1) du convertisseur analogique / numérique à un signal de sortie (Vdac) du convertisseur numérique / analogique délivrant un premier signal de comparaison (Vcomp33),
ledit convertisseur analogique / numérique à approximations successives étant synchronisé par un signal d'horloge provenant d'une horloge de conversion.

Selon l'invention, un tel procédé comprend des moyens (760) d'adaptation dynamique de la période de l'horloge de conversion en fonction d'au moins un paramètre.

## Description

### 1. Domaine de l'invention

Le domaine de l'invention est celui des convertisseurs analogique / numérique et plus particulièrement des convertisseurs analogique / numérique de type à approximations successives (appelés en anglais « successive approximation analog to digital converter »).

Plus précisément, l'invention concerne la génération de l'horloge d'un convertisseur analogique / numérique de type à approximations successives (ci-après désigne par CAN à approximations successives).

### 2. Solutions de l'art antérieur

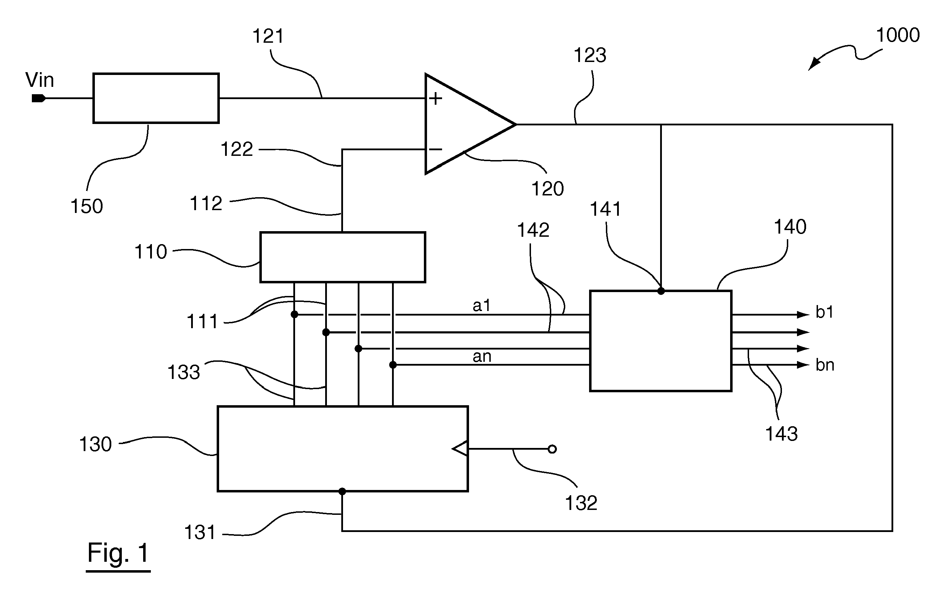

On présente, en relation avec la ***figure 1**,* un schéma simplifié d'un convertisseur analogique/numérique à approximations successives 1000 classique.

Le CAN à approximations successives 1000 comprend :
- un convertisseur numérique / analogique 110 (ci-après référence CNA) ;
- un échantillonneur bloqueur 150 (ou « sample and hold device » en anglais), dont l'entrée correspond à l'entrée du CAN à approximations successives 1000 et est donc alimentée avec la tension d'entrée du CAN 1000, ci-après référencée tension VIN, et dont la sortie, fournissant une tension, ci-après référencée tension Vin1, est reliée à l'entrée d'un comparateur 120 ci-après décrit. La tension Vin1 est égale à la tension d'entrée Vin à la fin de la phase d'échantillonnage (ci-après décrite). L'échantillonneur bloqueur 150 permet de stabiliser la tension d'entrée Vin du CAN à approximations successives 1000 pendant la phase de conversion ;
- un comparateur 120 dont une première entrée 121 est alimentée avec la tension de sortie Vin1 de l'échantillonneur bloqueur 150, une seconde entrée 122 est alimentée avec une tension de sortie (analogique) du CNA 110 (ci-après référencé Vdac) délivrée sur une sortie 112 du CNA 110 et une sortie 123 délivrant une tension de sortie ci-après référencée Vcomp ;
- un registre d'approximations successives 130 (ou SAR pour « Successive Approximation Register ») dont une première entrée 131 est alimentée par la tension de sortie Vcomp, une seconde entrée 132 est alimentée avec une tension délivrée par une horloge de conversion ci-après référencée CLK et un ensemble de n sorties (ci-après référencée a1, a2, ..., an) 133 (n entier naturel par exemple égal à 10) qui alimentent n entrées 111 du CNA 110 ;
- un circuit (optionnel) de stockage du résultat de la conversion 140 dont une première entrée 141 est alimentée par la tension de sortie Vcomp, n secondes entrées 142 sont reliées respectivement aux n sorties 133 du registre 130 et n sorties (ci-après référencées b1 à bn) 143 délivrent la tension de sortie du CAN à approximations successives ci-après référencée Vout.

Un cycle de conversion complet comprend une phase d'échantillonnage et une phase de conversion. Un tel cycle nécessite m période (s) de l'horloge de conversion (m entier naturel supérieur ou égal a un) pour l'échantillonnage et n période (s) de l'horloge de conversion pour la conversion analogique - numérique (n étant le nombre de bits). Par exemple, on suppose dans la suite que la conversion s'effectue sur n = 10 bits et que l'échantillonnage s'effectue sur 3 bits.

La période de l'horloge de conversion d'un tel CAN à approximations successives classique 1000 est fixée initialement et reste constante pendant tout le cycle de conversion.

Le choix de la période de l'horloge de conversion dépend du temps d'établissement du CNA 110 et du temps de réponse du comparateur 120.

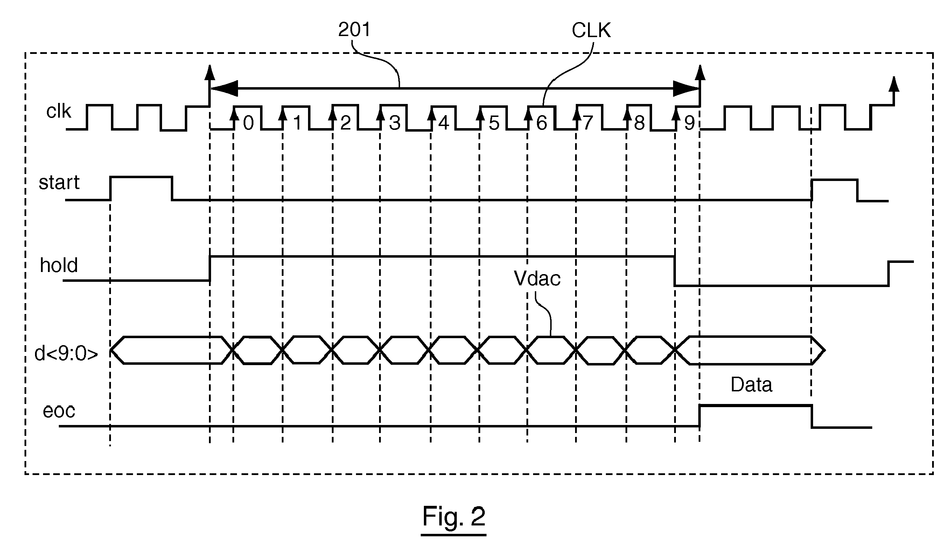

On présente, en relation avec la ***figure 2**,* des courbes des tensions CLK et des signaux référencés d<9:0> issus des sorties b1 à bn en fonction du temps sur une phase de conversion (étape 0 à étape 9).

Pendant une phase de conversion 201, la sortie 112 du CNA 110 génère une tension de sortie Vdac qui prend, dans une première étape de conversion, une première valeur Vref / 2 (ce qui correspond à un « 1 » sur le bit de la sortie a1 du SAR 130). Dans une seconde étape de conversion, en fonction de la tension sur la sortie 123 du comparateur 120, la sortie a1 est maintenue à « 1 » ou remise à « 0 » et la sortie Vdac prend la valeur a1*Vref/2 + Vref/4 (ce qui correspond à un « 1 » sur le bit de la sortie a2 du SAR 130), ... Dans une dixième étape de conversion, en fonction de la tension sur la sortie 123 du comparateur 120, la sortie a9 est maintenue à « 1 » ou remise à « 0 , la tension Vdac prend une valeur a1*Vref/2 + a2*Vref/4 + a3*Vref/8 + a4*Vref/16 + a5*Vref/32 + a6*Vref/64 + a7*Vref/128 + a8*Vref/256 + a9*Vref/512 + Vref/1024 (ce qui correspond à un « 1 » sur le bit de la sortie a10 du SAR 130), Vref étant une tension de référence constante. Enfin, en fonction de la tension sur la sortie 123 du comparateur 120, la sortie a10 est maintenue à « 1 » ou remise à« 0 ».

On appelle ci-après bit le plus significatif (ci-après désigné par MSB pour « Most Significant Bit ») le bit de la sortie a1 et bit le moins significatif (ci-après désigné par LSB pour « Less Significant Bit ») le bit de la sortie a10.

Lors du parcours d'une phase de conversion, pour chacune des étapes précitées, le comparateur 120 compare la tension de sortie Vdac à la tension d'entrée Vin. Les résultats ci-après référencés b1, b2, ... et b10 de ces comparaisons sont stockés dans le circuit de stockage du résultat de la conversion 140.

La fréquence de l'horloge est limitée à la fois par le temps d'établissement du convertisseur CNA 110 et par le temps de réponse du comparateur 120.

Pour chaque étape de conversion de la phase de conversion, Vdac doit s'établir avec une précision au moins égale à la moitié de la valeur du bit le moins significatif (LSB) qui prend la valeur Vref/1024.

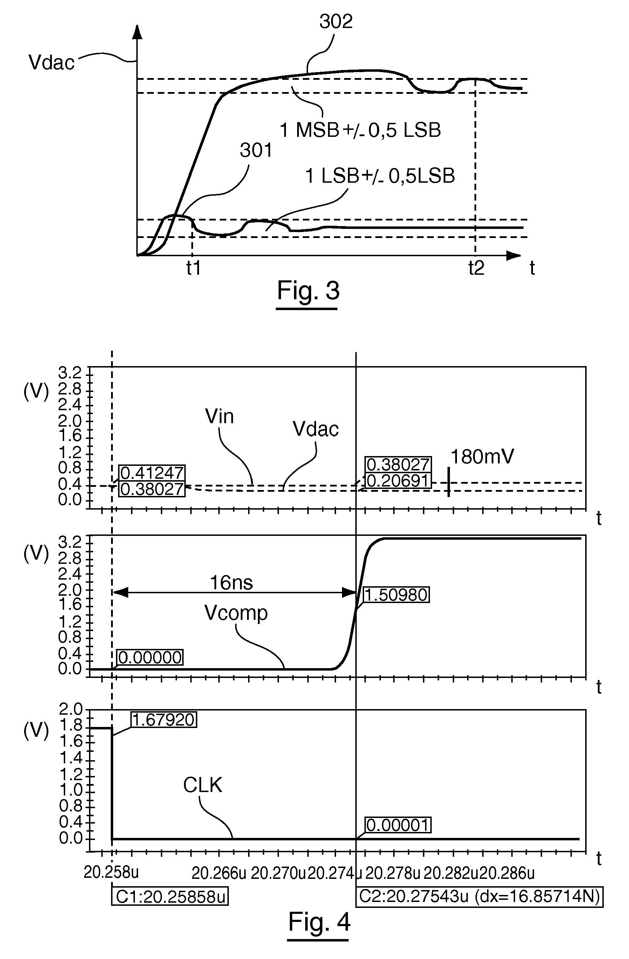

On présente, en relation avec la ***figure 3**,* l'évolution du signal Vdac en fonction du temps t dans le cas où Vdac prend la valeur du bit le moins significatif (courbe 301) et dans le cas où Vdac prend la valeur du bit le plus significatif (courbe 302).

Ainsi, Vdac prend un temps t1 pour s'établir avec une précision au moins égal à la moitié de la valeur du bit le moins significatif (LSB) et un temps t2 pour s'établir avec une précision au moins égal à la moitié de la valeur du bit le moins significatif (LSB). On peut noter que t1 est très inférieur a t2.

La tension de sortie Vcomp du comparateur 120 peut commuter de 0 à 1 ou de 1 a 0. Le temps de réponse du comparateur 120 dépend de la valeur absolue de la différence entre la tension d'entrée Vin du CAN à approximations successives 1000 et de la tension de sortie Vdac du CNA 110.

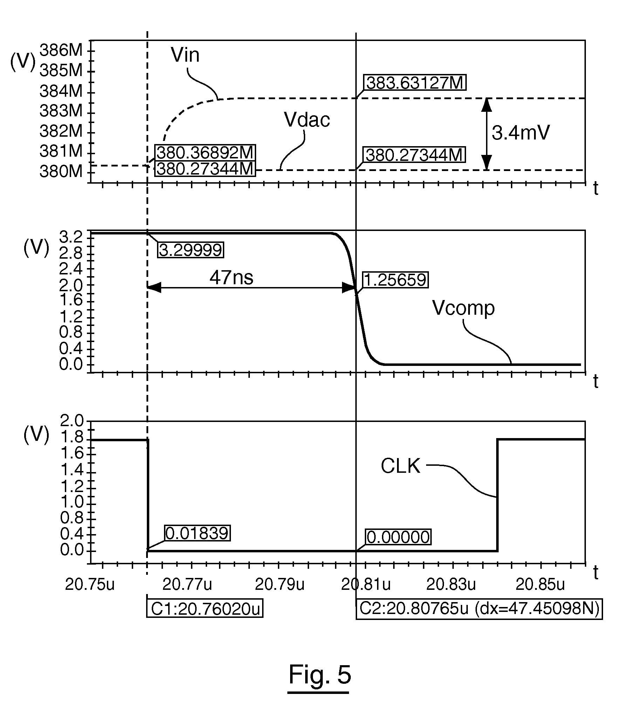

On présente, en relation avec les ***figures 4 et 5***, des courbes des tensions Vin, Vdac, Vcomp et CLK (en V) en fonction du temps t (en s) respectivement dans un cas où la tension Vdac vaut sensiblement 0,207V et Vin vaut sensiblement 0,380 V (figure 4) et dans un cas où la tension Vdac vaut sensiblement 0,380V et Vin vaut sensiblement 0,383 V (figure 5).

Ainsi, dans le cas où la tension Vdac vaut sensiblement 0,207V et Vin vaut sensiblement 0,380 V, le temps de réponse du comparateur 120 vaut 16ns et dans le cas où la tension Vdac vaut sensiblement 0,380V et Vin vaut sensiblement 0,383 V, le temps de réponse du comparateur 120 vaut 47ns.

En conséquence, plus la valeur absolue de la différence entre Vin et Vdac est faible, plus le temps de réponse du comparateur 120 est important.

Une nouvelle valeur de la tension de sortie du CNA 110 (correspondant à une nouvelle étape de la conversion) est appliquée à la seconde entrée 122 du comparateur 120 de manière synchronisée avec une montée ou une descente courante de la tension d'horloge CLK, puis la valeur de la tension de sortie du comparateur 120 correspondant à la comparaison de cette nouvelle valeur de la tension de sortie du CNA 110 avec Vin1 est mémorisée lors de la montée ou descente suivante de la tension d'horloge CLK.

Ainsi, la période minimale de l'horloge de conversion correspond à la somme du temps d'établissement du convertisseur CNA 110 et du temps de réponse du comparateur 120.

Dans un CAN à approximations successives classique, afin de s'assurer que la période de l'horloge de conversion sera suffisamment longue pour que la conversion puisse être effectuée avec la précision requise pour toutes les valeurs du signal Vin, on choisit généralement une période de l'horloge constante et égale à la somme du temps d'établissement du convertisseur CNA dans le cas du bit le plus significatif (MSB) et du temps de réponse du comparateur dans le cas de la plus faible différence (sensiblement égale à la valeur du bit le moins significatif ou LSB) entre la tension Vin et la tension Vdac.

On se place ainsi, dans le cas le moins favorable en terme de rapidité de la conversion et ainsi, on observe une perte de temps, à chacune des étapes de conversion de la phase de conversion, dans la conversion pour la majorité des tensions d'entrée Vin.

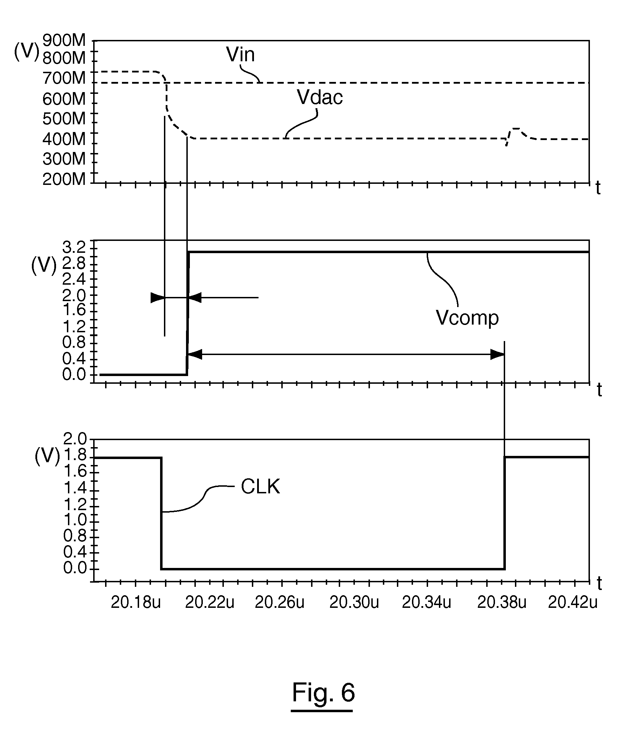

On illustre cette perte de temps, en relation avec la ***figure 6**,* qui présente des courbes des tensions Vin, Vdac, Vcomp et CLK (en V) en fonction du temps t (en µs) dans un cas où Vin vaut sensiblement 0,7 V et où la période de l'horloge de conversion est sensiblement égale a 0,2µs.

On observe une commutation du comparateur 120 au moment où Vdac prend une valeur d'environ 0,4V. On peut observer que la somme du temps d'établissement du convertisseur CNA 110 afin que Vdac soit égale à 0,4V et du temps de réponse du comparateur (qui est de l'ordre de 0,02µs) est bien inférieur à la période de l'horloge de conversion. On observe ainsi, dans le cas de cette étape de conversion un temps perdu de sensiblement 0,18 µs.

### 3. Objectifs de l'invention

L'invention a notamment pour objectif de pallier ces inconvénients de l'art antérieur.

Plus précisément, un objectif de l'invention, dans au moins un de ses modes de réalisation, est de fournir une technique permettant d'améliorer la rapidité de conversion d'un convertisseur analogique/numérique à approximations successives.

Un autre objectif de l'invention, dans au moins un de ses modes de réalisation, est de mettre en oeuvre une telle technique qui permette notamment de réduire, lors de la phase de conversion, le temps perdu dû à la période de l'horloge de conversion.

L'invention, dans au moins un de ses modes de réalisation, a encore pour objectif de fournir une telle technique qui soit simple à mettre en oeuvre et pour un faible coût.

### 4. Expose de l'invention

conformément à un mode de réalisation particulier, l'invention concerne un convertisseur analogique / numérique à approximations successives comprenant un registre à approximations successives alimentant un convertisseur numérique / analogique, des premier moyens de comparaison d'un signal d'entrée du convertisseur analogique / numérique a un signal de sortie du convertisseur numérique / analogique délivrant un premier signal de comparaison, ledit convertisseur analogique / numérique à approximations successives étant synchronise par un signal d'horloge provenant d'une horloge de conversion,

Selon l'invention, le convertisseur comprend des moyens d'adaptation dynamique de la période de l'horloge de conversion en fonction d'au moins un paramètre.

Le principe général de l'invention repose sur une adaptation dynamique de la période de l'horloge de conversion d'un CAN à approximations successives de sorte que la période soit réduite lorsque cela n'est pas dommageable pour la qualité de la conversion.

Ainsi, cette adaptation dynamique de la période de l'horloge de conversion permet d'améliorer la rapidité de conversion d'un convertisseur analogique/numérique à approximations successives.

Cette adaptation permet notamment de réduire, par rapport au cas d'une horloge dont la période est constante, lors de la phase de conversion, le temps perdu dû à la période de l'horloge de conversion.

Préférentiellement, les moyens d'adaptation dynamique de la période de l'horloge de conversion comprennent des moyens de mesure d'au moins un temps de réponse des premiers moyens de comparaison et/ou des moyens de mesure d'au moins un temps d'établissement d'au moins une tension analogique par le convertisseur numérique - analogique.

Ainsi, le paramètre est par exemple au moins un temps de réponse des premiers moyens de comparaison et-ou au moins un temps d'établissement d'au moins une tension analogique par le convertisseur numérique / analogique.

Selon une caractéristique avantageuse de l'invention, les moyens de mesure comprennent des seconds moyens de comparaison du signal d'entrée du convertisseur analogique / numérique au signal de sortie du convertisseur numérique / analogique délivrant un second signal de comparaison alimentant des moyens de génération de ladite horloge de conversion et les moyens de génération de ladite horloge de conversion tiennent compte desdits premier et second signaux de comparaison.

Avantageusement, les moyens de mesure sont adaptés à mesurer également au moins un temps de réponse des seconds moyens de comparaison.

Préférentiellement, les premiers moyens de comparaison comprennent un premier comparateur, les seconds moyens de comparaison comprennent un second comparateur et les premier et second comparateurs sont identiques.

Selon un mode de mise en oeuvre de l'invention, les seconds moyens de comparaison comprennent des moyens de multiplexage du signal d'entrée du convertisseur analogique / numérique et du signal de sortie du convertisseur numérique / analogique sur des première et seconde entrées du second comparateur tenant compte du signal d'horloge.

Avantageusement, les moyens de multiplexage comprennent au moins un interrupteur commande par le signal d'horloge et au moins un interrupteur commande par l'inverse du signal d'horloge.

Avantageusement, lesdits moyens de génération de l'horloge de conversion comprennent au moins une porte OU exclusif.

Préférentiellement, lesdits moyens de génération de l'horloge de conversion comprennent des moyens de temporisation appliqués sur ledit signal d'horloge.

Ainsi, une temporisation permet de garantir une largeur minimum à la période d'horloge notamment pour la logique mise en oeuvre dans le registre à approximations successives.

Selon un mode de mise en oeuvre de l'invention, les moyens de génération de l'horloge de conversion comprennent des moyens de diminution de la période du signal d'horloge.

Ainsi, on peut obtenir un signal d'horloge dont la période d'horloge est optimisée tout au long de la phase de conversion.

Avantageusement, lesdits moyens de diminution de la période d'horloge comprennent deux inverseurs montés en série.

Préférentiellement, les moyens d'adaptation dynamique de la période de l'horloge de conversion comprennent des moyens d'isolation du convertisseur analogique / numérique d'un bruit généré par les moyens d'adaptation dynamique.

Préférentiellement, lesdits moyens d'isolation comprennent au moins un montage amplificateur suiveur.

Selon un mode de mise en oeuvre de l'invention, ledit au moins un paramètre appartient au groupe comprenant les :
- Temps de réponse des premiers moyens de comparaison ;
- temps d'établissement d'au moins une tension analogique par le convertisseur numérique - analogique ;
- signal d'entree du convertisseur analogique / numérique ;
- température de fonctionnement du convertisseur analogique / numérique ;
- process de fabrication du convertisseur analogique / numérique.
   L'invention concerne également un composant intégré comprenant au moins un convertisseur analogique / numérique à approximations successives tel que précédemment décrit.
   L'invention concerne également un procédé de conversion par approximations successives d'un signal analogique d'entrée en un signal numérique de sortie mis en oeuvre par un convertisseur analogique / numérique a approximations successives comprenant un registre à approximations successives alimentant un convertisseur numérique / analogique, des premier moyens de comparaison d'un signal d'entrée du convertisseur analogique / numérique à un signal de sortie du convertisseur numérique / analogique délivrant un premier signal de comparaison,
   ladite conversion par approximations successives étant synchronisées par un signal d'horloge provenant d'une horloge de conversion,
   Selon l'invention, le procédé comprend une étape d'adaptation dynamique de la période de l'horloge de conversion en fonction d'au moins un paramètre.
   Les avantages du composant intégré et du procédé de conversion par approximations successives sont sensiblement les mêmes que ceux du procédé de gestion, ils ne sont pas détaillés plus amplement.

### 5. Liste des figures

D'autres caractéristiques et avantages de l'invention apparaîtront plus clairement à la lecture de la description suivante de modes de réalisation particuliers, donnés à titre de simples exemples illustratifs et non limitatifs, et des dessins annexes, parmi lesquels :
- la figure 1 un schéma simplifié d'un convertisseur analogique/numérique a approximations successives classique ;
- la figure 2 présente des courbes des tensions CLK et des signaux issus des sorties b1 à bn en fonction du temps sur une phase de conversion du CAN à approximations successives classique de la figure 1 ;
- la figure 3 présente des courbes du signal Vdac en fonction du temps t dans le cas où Vdac prend la valeur du bit le moins significatif (courbe 301) et dans le cas où Vdac prend la valeur du bit le plus significatif (courbe 302) ;
- les figures 4 et 5 présentent des courbes des tensions Vin, Vdac, Vcomp et CLK (en V) en fonction du temps t (en s) respectivement dans un cas où la tension Vdac vaut sensiblement 0,207V et Vin vaut sensiblement 0,380 V (figure 4) et dans un cas où la tension Vdac vaut sensiblement 0,380V et Vin vaut sensiblement 0,383 V (figure 5) ;
- la figure 6 présente des courbes des tensions Vin, Vdac, Vcomp et CLK (en V) en fonction du temps t (en µs) dans un cas où Vin vaut sensiblement 0,7 V et où la période de l'horloge de conversion est sensiblement égale a 0,2µs ;
- la figure 7 présente un schéma simplifie d'un convertisseur analogique / numérique à approximations successives selon un mode de réalisation particulier de l'invention ;
- la figure 8 présente un schéma détaille du circuit d'adaptation dynamique de la période de l'horloge de conversion selon un mode de mise en oeuvre particulier de l'invention du CAN à approximations successives de la figure 7 ;
- la figure 9 présente des courbes présentant l'évolution, en fonction du temps t, des tensions Vstart, Veoc, Vdac, Vin, Vcomp33, Vnet145, VCLKREF, Vincomp1 et Vincomp2 au début d'une phase de conversion du CAN à approximations successives de la figure 7 ;
- la figure 10 présente un schéma d'une implémentation particulière du convertisseur analogique / numérique à approximations successives de la figure 7 ;
- les figures 11A à 11D sont des diagrammes représentant la distribution en fréquence de l'erreur et du temps de conversion dans le cas où une adaptation dynamique, conforme à l'invention, de la période de l'horloge de conversion est mise en oeuvre (figure 11C et 11D) et dans le cas classique où la période de l'horloge de conversion est constante (figure 11A et 11B).

### 6. Description d'un mode de réalisation de l'invention

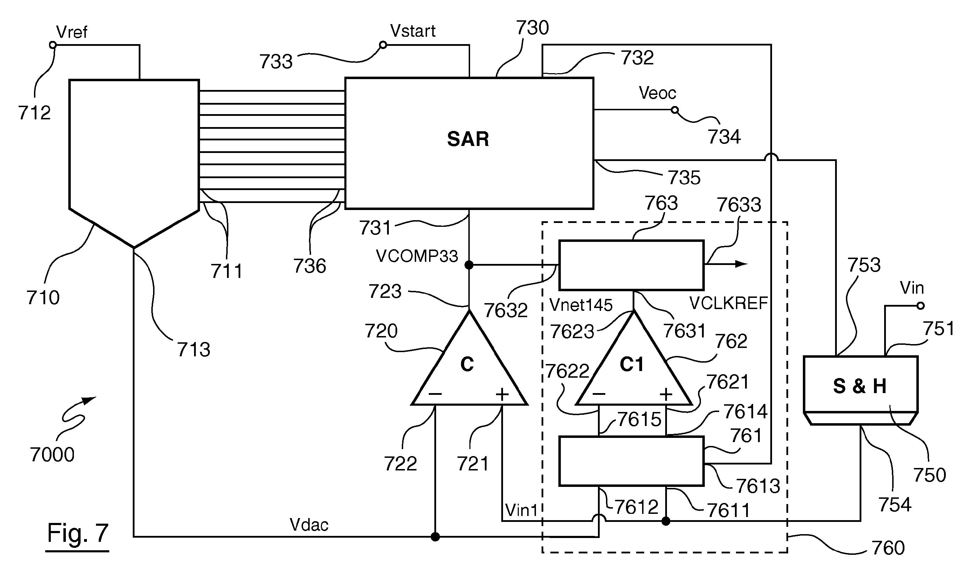

On présente, en relation avec la ***figure* 7**, un schéma simplifié d'un convertisseur analogique / numérique a approximations successives selon un mode de réalisation particulier de l'invention.

Le CAN à approximations successives 7000 comprend
- un convertisseur numérique / analogique 710 (ci-après référencé CNA) alimenté en une première entrée 712 par une tension (ou signal) de référence constante Vref ;
- un échantillonneur bloqueur 750 dont une première entrée 751 est alimentée avec la tension (ou signal) d'entrée Vin (analogique) du CAN a approximations successives, une seconde entrée 753 est reliée à une première sortie 735 du SAR 730 qui délivre un signal de blocage ci-après référencé Vhold et une sortie 754 délivre un signal Vin1 dont la valeur est stable et dont la valeur est égale à celle de la tension d'entrée Vin à la fin de la période d'échantillonnage, pendant la phase de conversion ;
- un premier comparateur 720 dont une première entrée 721 est alimentée avec la tension (ou signal) Vin1 délivrée à la sortie 754 de l'échantillonneur bloqueur 750, une seconde entrée 722 est alimentée avec une tension (ou signal) de sortie (analogique) du CNA 710 (ci-après référencée Vdac) délivrée sur une sortie 713 du CNA 710 et une sortie 723 délivre une tension (ou signal) de sortie (ou première tension de comparaison issue de la comparaison des tensions Vin1 et Vdac) ci-après référencée Vcomp33 ;
- un registre à approximations successives 730 (ou SAR pour « Successive Approximation Register ») dont une première entrée 731 est alimentée par la tension de sortie Vcomp33, une seconde entrée 732 est alimentée avec une tension (ou signal) d'horloge (ci-après référencée VCLKREF) délivrée par un circuit 760 d'adaptation dynamique de la période de l'horloge de conversion ci-après décrit, une troisième entrée 733 est alimentée par un signal d'initialisation ci-après référencé « Vstart », une sortie 734 délivrant un signal d'indication de fin de cycle de conversion (ou EOC pour « End Of Cycle ») ci-après référencé Veoc et un ensemble de n secondes sorties (ci-après référencées par a1 à a10) 736 (n est le nombre de bits de la conversion, on le choisit dans la suite, par exemple, égal à 10) qui alimentent n secondes entrées 711 du CNA 710 ;
- un circuit 760 d'adaptation dynamique de la période de l'horloge de conversion du CAN à approximations successives 7000.

On peut noter que le CAN à approximation successive 7000 selon l'invention peut, de la même manière que le CAN à approximation successive 1000 de la figure 1, comprendre (optionnellement) un circuit de stockage (non représenté sur les figures 7, 8 et 10) servant à mémoriser les résultats en fin de conversion. Ce circuit de stockage n'étant pas indispensable au fonctionnement du CAN à approximation successive selon l'invention.

Dans le présent mode de réalisation particulier de l'invention, ce circuit 760 comprend un multiplexeur 761, un second comparateur 762, identique au premier comparateur 720, et un générateur d'horloge 763.

Le multiplexeur 761 comprend :
- une première entrée 7611 reliée à la sortie 754 (délivrant la tension Vin1) de l'échantillonneur bloqueur 750 ;
- une seconde entrée 7612 reliée à la sortie 713 du CNA 710 délivrant la tension Vdac ;
- une troisième entrée 7613 reliée à une sortie 7633 (délivrant la tension d'horloge VCLKREF) du générateur d'horloge 763 ;
- une première sortie 7614 reliée à une première entrée 7621 du second comparateur 762 ; et
- une seconde sortie 7615 reliée à une seconde entrée 7622 du second comparateur 762.

Le multiplexeur 761 joue le rôle de commutateur reliant respectivement les signaux Vin1 et Vdac aux première 7621 et seconde 7622 entrées du second comparateur 762 pendant la demi-période d'horloge CLKREF, et respectivement aux seconde 7622 et première 7621 entrées du second comparateur 762 pendant la demi-période d'horloge CLKREF.

Le second comparateur 762 comprend une sortie 7623 délivrant une tension de sortie (ou seconde tension de comparaison) ci-après référencée Vnet145 (issue de la comparaison des tensions appliquées sur ses première 7621 et seconde 7622 entrées par les première 7614 et seconde 7615 sorties du multiplexeur 761) et reliée à une première entrée 7631 du générateur d'horloge 763.

Le générateur d'horloge 763 comprend une première entrée 7631 reliée à la sortie 7623 second comparateur 762, une seconde entrée 7632 reliée à la sortie 723 délivrant la tension Vcomp33 du premier comparateur 720 et une sortie 7633 qui délivre la tension d'horloge VCLKREF et qui est connectée à la seconde entrée 732 du registre à approximations successives 730 et à la troisième entrée 7613 du multiplexeur 761.

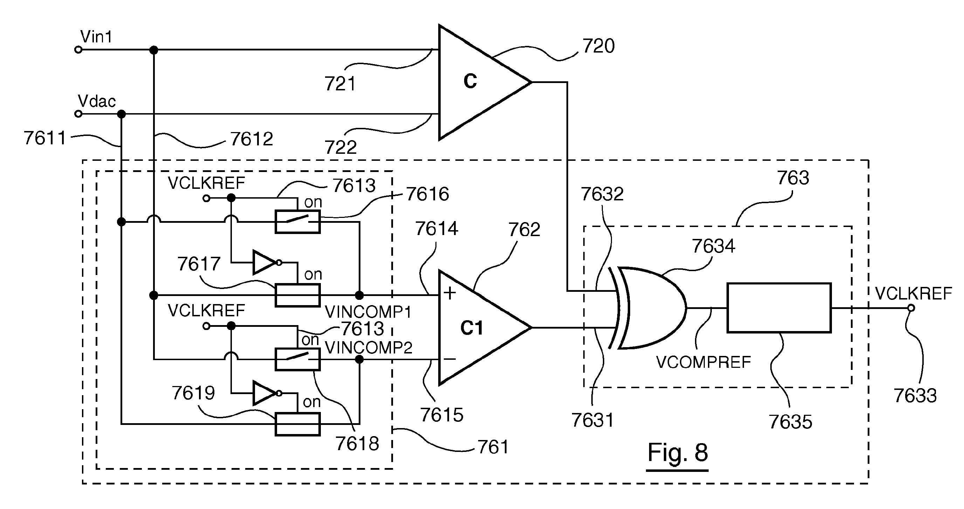

On présente, en relation avec la ***figure 8,*** un schéma détaillé du circuit 760 d'adaptation dynamique (présenté en figure 7) de la période de l'horloge de conversion selon un mode de mise en oeuvre particulier de l'invention.

Ainsi, le multiplexeur 761 est réalisé au moyen de :
- premier 7616 et second 7617 interrupteurs reliant respectivement la première 7611 entrée du multiplexeur 761 (qui reçoit la tension Vdac) a la première 7614 sortie du multiplexeur 761 (qui délivre une tension ci-après référencée Vincomp1) et la seconde 7612 entrée du multiplexeur 761 (qui reçoit la tension Vin1) a la première 7614 sortie du multiplexeur 761 (qui délivre une tension ci-après référencée Vincomp2) et qui sont respectivement commandes par la tension VCLKREF et par l'inverse de la tension VCLKREF ;
- troisième 7618 et quatrième 7619 interrupteurs reliant respectivement la seconde 7612 entrée du multiplexeur 761 (qui reçoit la tension Vin1) a la seconde 7615 sortie du multiplexeur 761 (qui délivre une tension ci-après référencée Vincomp2) et la première 7611 entrée du multiplexeur 761 (qui reçoit la tension Vdac) a la seconde 7615 sortie du multiplexeur 761 (qui délivre une tension ci-après référencée Vincomp1) et qui sont respectivement commandes par la tension VCLKREF et par l'inverse de la tension VCLKREF.

Le générateur d'horloge 763 est réalisé au moyen d'une porte OU exclusif dont les première et seconde entrées sont reliées aux première 7631 et secondes 7632 entrées du générateur d'horloge 763 et dont la sortie, délivrant une tension de sortie ci-après référencée VCOMPREF, est reliée à l'entrée d'une temporisation 7635 (qui fait également partie du générateur d'horloge 763) dont la sortie est reliée à la sortie 763 du générateur d'horloge 763 (qui délivre la tension VCLKREF).

Il est à noter que le générateur d'horloge 763 peut ne pas comprendre de temporisation.

Pendant une phase de conversion, la sortie 713 du CNA 710 génère des tensions Vdac décroissantes, selon le principe connu des convertisseurs à approximations successives et décrit précédemment. Dans une première étape de conversion, Vdac prend une première valeur Vref /2 (ce qui correspond à un 1 sur la seconde sortie a1 du SAR 730).

Les bits délivrés par les secondes sorties a1 et a10 du SAR 730 sont respectivement le bit le plus significatif (MSB) et bit le moins significatif (LSB).

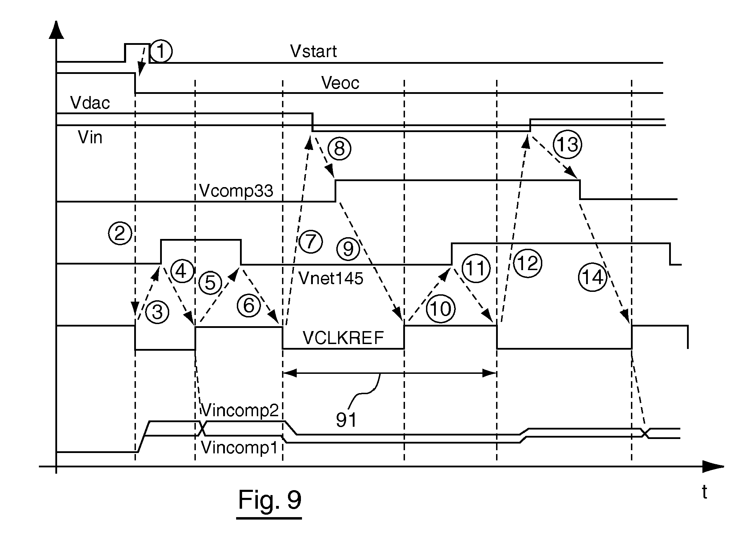

Le registre à approximations successives 730 séquence la conversion analogique / numérique (telle que détaillée ci-après en relation avec la figure 9) a en imposant une valeur de 1 au bit le plus significatif (MSB) de la seconde sortie a1 du SAR 730, puis il contrôle la sortie 723 du premier comparateur 720 afin de vérifier si la tension Vdac est supérieure ou inférieure a la tension Vin1. La tension Vin1 est égale à la tension Vin à la fin de la phase d'échantillonnage.

Si la tension Vdac est supérieure à Vin, alors le registre à approximations successives 730 impose un 0 sur le bit de la seconde sortie a1 (MSB) du SAR 730 et il impose une valeur 1 au bit de la seconde sortie a2 du SAR 730, ensuite le contrôle de la sortie du premier comparateur 720 est répété.

Dans le cas contraire, si la tension Vin est supérieure à la tension Vdac, alors le registre à approximations successives 730 maintient un 1 sur le bit de la seconde sortie a1 (MSB) du SAR 730 et il impose une valeur 1 au bit de la seconde sorties a2 du SAR 730, ensuite le contrôle de la sortie du premier comparateur 720 est répété.

Ainsi, le temps nécessaire a la phase de conversion d'une tension analogique en une tension numérique sur 10 bits est de n = 10 périodes d'horloge de conversion (n est le nombre de bits du convertisseur analogique / numérique). A ce temps s'ajoute la durée (m périodes d'horloge) de la phase d'échantillonnage, pendant laquelle la sortie Vin est reliée a la sortie Vin1. La durée totale de la conversion est de (m+n) périodes d'horloge.

L'échantillonneur bloqueur 750 est utilise pour échantillonner la tension d'entrée Vin du CAN à approximations successives 7000 lors de la phase d'échantillonnage et pour la maintenir stable pendant la phase de conversion.

Conformément a l'invention, le circuit 760 d'adaptation dynamique de la période de l'horloge de conversion est utilisé pour générer une tension d'horloge VCLKREF dont la période et le rapport cyclique sont adaptés dynamiquement pour chacun des n =10 périodes d'horloge, notamment en fonction :
- du temps d'établissement du convertisseur CNA 710 (dépendant de la tension Vdac à établir) et
- du temps de réponse du premier comparateur 720, de celui du second comparateur 762 et du multiplexeur 761 (dépendant notamment de la différence de tension entre Vin et Vdac).

Selon des variantes de ce mode de réalisation de l'invention, la période de l'horloge de conversion est adaptée dynamiquement, notamment en fonction de l'un au moins des paramètres suivants :
- temps d'établissement du convertisseur CNA 710 (dépendant de la tension Vdac à établir) et
- temps de réponse du premier comparateur 720, de celui du second comparateur 762 et du multiplexeur 761 (dépendant notamment de la différence de tension entre Vin et Vdac) ;
- signal d'entrée Vin du convertisseur analogique / numérique ;
- température de fonctionnement du CAN 7000 ;
- process de fabrication du CAN 7000.

Cette adaptation est réalisée grâce à la mesure du temps d'établissement de la tension de sortie des premier comparateur 720 et second comparateur 762. Cette mesure prend en compte le temps d'établissement du CNA 710. Les transitions d'horloge ont lieu soit sur la première 723 ou sur la seconde 763 sortie des comparateurs 720 et 762.

Tel qu'illustre ci-après, en relation avec la figure 9, le circuit d'adaptation 760 assure la génération de deux transitions pour chaque période de l'horloge de conversion VCLKREF quelles que soient la tension Vref et la tension Vin à convertir.

En effet, la tension Vcomp33, qui dépend de la valeur absolue de la différence entre les tensions Vin et Vdac ne commute pas de 0 à 1 à chaque étape de conversion. Ainsi, le multiplexeur 761 et le premier comparateur 762 du circuit d'adaptation 760 sont charges de générer les transitions d'horloge manquantes qui ne peuvent être extraites de la tension Vcomp33.

Les tensions Vincomp1 et Vincomp2 sont respectivement égales a Vdac et Vin pendant une première partie d'une période d'horloge et respectivement égales a Vin et Vdac pendant une seconde partie de la période d'horloge. Ce mécanisme de commutation sur Vincomp1 et Vincomp2 permet la mesure du temps de réponse du premier comparateur 720 au niveau de la sortie 7623 du second comparateur 762 à chaque fin de première partie de période d'horloge et permet de fournir des transitions d'horloge supplémentaires (non présentes sur la sortie 723 du comparateur 720) sur la tension d'horloge VCLKREF pour chaque fin de la seconde partie de période d'horloge VCLKREF. La temporisation 7635 permet de garantir une largeur minimum de période d'horloge pour la logique du SAR 730.

On illustre, en relation avec la ***figure 9**,* le principe de fonctionnement du circuit 760 d'adaptation dynamique de la période de l'horloge de conversion selon un mode de mise en oeuvre particulier de l'invention pressente en relation avec les figures 7 et 8.

La figure 9 présente un exemple de l'évolution, en fonction du temps t, des tensions Vstart, Veoc, Vdac, Vin, Vcomp33, Vnet145, VCLKREF, Vincomp1 et Vincomp2 au début d'une phase de conversion.

Dans la suite, lorsque l'on parle de valeurs haute et basse d'une tension, on entend par exemple respectivement une valeur logique 1 et une valeur logique 0.

Avant le début de la phase de conversion, une phase d'échantillonnage est réalisée, par exemple, sur trois périodes d'horloge de conversion.

La tension Vref est une tension de référence constante préalablement choisie.Elle est égale à la tension d'entrée Vin maximale prévue en entrée du CAN à approximations successives 7000.

La tension Vref est liée a la technologie utilisée. Elle est, par exemple, comprise entre 1V et 1,8V pour une technologie 0,18µm.

La tension Vin d'entrée donnée du CAN 7000 est stockée dans l'échantillonneur bloqueur 750 pendant la phase d'échantillonage.

A la fin de la phase d'échantillonnage, la tension Vin appliquée sur la première entrée 721 du premier comparateur 720 et sur la première entrée 7611 du multiplexeur 761 est égale à vin1.

Dans une sous-étape 1, une impulsion du signal Vstart est appliquée sur la troisième entrée 733 du registre à approximations successives 730. Puis, la tension Veoc passe d'une valeur haute à une valeur basse (par exemple 0V). De même, la tension VCLKREF passe d'une valeur haute à une valeur basse.

Puis, dans une sous-étape 2, le CAN 7000 commute de la phase d'échantillonnage à la phase de conversion. La tension a la sortie de l'échantillonneur bloqueur 750 reste figée à Vin1 pendant la phase de conversion, lorsque la seconde entrée 753 est forcée a 1 par le SAR 730. L'échantillonneur bloqueur 750 passe alors en mode «maintiens de la tension d'entrée ».

Par exemple, on choisit une valeur de Vin qui est comprise entre Vref / 4 et Vref / 4 + Vref / 8.

Du fait que le signal Veoc est dans sa valeur basse, la tension VCLKREF est une copie de la tension VCOMPREF décalée par la temporisation 7635 (tel qu'indique ci-dessus, une telle temporisation 7635 est mise en oeuvre afin de garantir une valeur minimale à la période de l'horloge de conversion). Par exemple, la temporisation est de 20ns.

Ainsi, le CNA 710 applique une tension Vref / 2 correspondant au MSB sur la seconde entrée 722 du premier comparateur 720 et sur l'entrée 7612 du multiplexeur 761.

Du fait que la tension Vin1 appliquée sur la première entrée 721 du premier comparateur 720 et l'entrée 7611 du multiplexeur 761 est inférieure à la tension Vdac = Vref / 2 appliquée sur la seconde entrée 722 du premier comparateur 720 et sur l'entrée 7612 du multiplexeur 761, la tension Vcomp33 (délivrée par la sortie 723 du premier comparateur 720) est à sa valeur basse.

Dans une sous étape 3, du fait que la tension VCLKREF est dans sa valeur basse, la tension Vincomp1 est égale a la tension Vdac (qui est également appliquée sur la seconde entrée 722 du premier comparateur 720) et la tension Vincomp2 est égale a la tension Vin1 (qui est également appliquée sur la première entrée 721 du premier comparateur 720), donc, après l'écoulement du temps de réponse du second comparateur 762 (qui dépend de la différence entre la tension Vincomp1 = Vdac et la tension Vincomp2 = Vin1, la tension Vnet145 prend sa valeur haute.

Donc, la tension VCOMPREF, qui est la sortie de la porte OU exclusif 7634 (sur laquelle est appliquée Vcomp33 et Vnet145), prend sa valeur haute.Ainsi, VCLKREF prend sa valeur haute (après le décalage dû a la temporisation 7635) dans une sous étape 4.

Dans une sous-étape 5, du fait que la tension VCLKREF est dans sa valeur haute, la tension Vincomp1 est égale à la tension Vin1 (qui est également appliquée sur la première entrée 721 du premier comparateur 720) et la tension Vincomp2 est égale a la tension Vdac (qui est également appliquée sur la seconde entrée 722 du premier comparateur 720), donc, après l'écoulement du temps de réponse du second comparateur 762 (qui dépend de la différence entre la tension Vincomp1 = Vin1 et la tension Vincomp2 = Vdac), la tension Vnet145 prend sa valeur basse. Donc les entrées du second comparateur 762 sont inversées suite à la commutation de VCLKREF.

Donc, la tension VCOMPREF, qui est la sortie de la porte OU exclusif 7634 (sur laquelle est appliquée Vcomp33 et Vnet145), prend sa valeur basse.Ainsi, VCLKREF prend sa valeur basse (après le décalage dû a la temporisation 7635) dans une sous-étape 6.

Puis La valeur basse de la tension Vcomp33 entraîne une remise à 0 du bit le plus significatif (MSB) sur la seconde sortie a1 du registre à approximations successives 730 au moment où VCLKREF prend sa valeur basse.

Dans une sous-étape 7, le CNA 710 applique une tension Vref / 4 (après l'écoulement du temps d'établissement de cette tension Vref /4 par le CNA 710) sur la seconde entrée 722 du premier comparateur 720 et sur l'entrée 7612 du multiplexeur 761.

Du fait que la tension Vin1 appliquée sur la première entrée 721 du premier comparateur 720 est supérieure à la tension Vdac = Vref / 4 appliquée sur la seconde entrée 722 du premier comparateur 720, dans une sous-étape 8, la tension Vcomp33 prend sa valeur haute après l'écoulement du temps de réponse du premier comparateur 720 (qui dépend de la différence entre la tension Vin1 et la tension Vdac = Vref / 4).

Du fait que la tension VCLKREF est dans sa valeur basse, la tension Vincomp1 est égale à la tension Vdac et la tension Vincomp2 est égale à la tension Vin1 (qui est supérieure à la tension Vdac), donc, la tension Vnet145 conserve sa valeur basse.

Donc, la tension VCOMPREF prend sa valeur haute.Ainsi, VCLKREF prend sa valeur haute (après le décalage du a la temporisation 7635) dans une sous-étape 9.

Dans une sous-étape 10, du fait que la tension VCLKREF est dans sa valeur haute, la tension Vincomp1 devient égale à la tension Vin1 et la tension Vincomp2 devient égale à la tension Vdac (qui est inférieure à Vin), donc, après l'écoulement du temps de réponse du second comparateur 762 (qui dépend de la différence entre la tension Vincomp1 = Vin1 et la tension Vincomp2 = Vdac), la tension Vnet145 prend sa valeur haute.

Ainsi, dans une sous-étape 11, VCOMPREF qui est la sortie de la porte OU exclusif 7634 (sur laquelle est appliquée Vcomp33 et Vnet145) prend sa valeur basse et VCLKREF prend sa valeur basse (après le décalage dû a la temporisation 7635). Donc les entrées du second comparateur 762 sont inversées suite à la commutation de VCLKREF.

Puis, du fait que la tension Vin1 est supérieure à la tension Vdac, la valeur de 1 est maintenue sur la seconde sortie a2 du registre à approximations successives 730 au moment où VCLKREF prend sa valeur basse.

Dans une sous-étape 12, le CNA 710 applique donc une tension Vref /4 + Vref / 8 (après l'écoulement du temps d'établissement de cette tension Vref /4 + Vref / 8 par le CNA 710) sur la seconde entrée 722 du premier comparateur 720 et sur l'entrée 7612 du multiplexeur 761.

Du fait que la tension Vin1 appliquée sur la première entrée 721 du premier comparateur 720 est inférieure a la tension Vdac = Vref / 4 + vref / 8 appliquée sur la seconde entrée 722 du premier comparateur 720, dans une sous-étape 13, la tension Vcomp33 prend sa valeur basse après l'écoulement du temps de réponse du premier comparateur 720 (qui dépend de la différence entre la tension Vin1 et la tension Vdac = Vref /4 + Vref /8).

Du fait que la tension VCLKREF est dans sa valeur basse, la tension Vincomp1 est égale à la tension Vin1 et la tension Vincomp2 est égale à la tension Vdac (qui est supérieure à la tension Vin1), donc, la tension Vnet145 conserve sa valeur haute.

Donc, la tension VCOMPREF prend sa valeur haute .Ainsi, VCLKREF prend sa valeur haute (après le décalage dû a la temporisation 7635) dans une sous-étape 14.

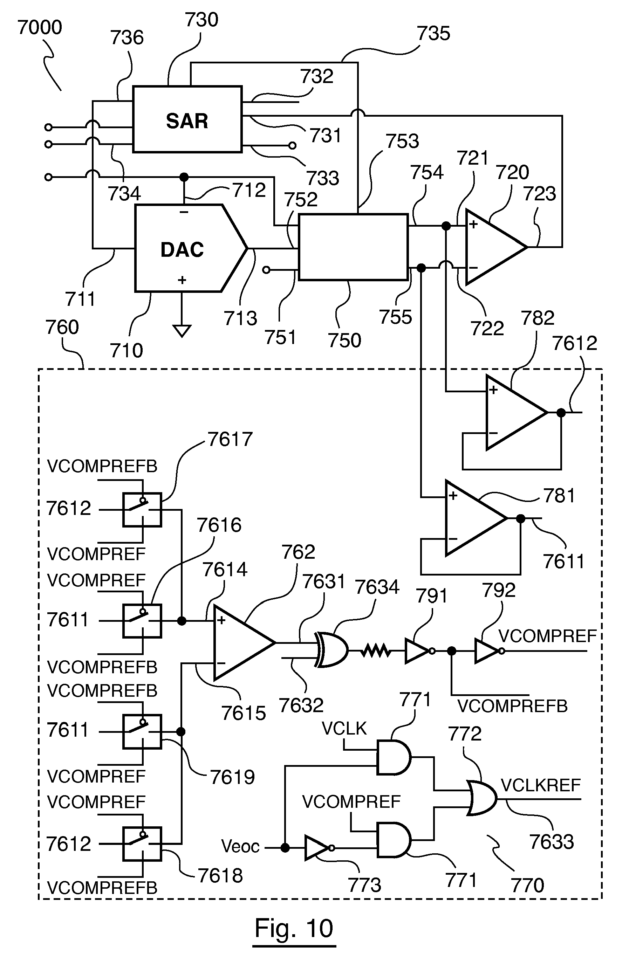

Le procédé est ainsi répété jusqu'à la fin de la phase de conversion (par soucis de clarté, on n'a représenté sur cette figure 9 que les sous-étapes 1 à 14). En effet, à la fin de la dixième période de l'horloge de conversion (donc à la fin de la dixième étape de conversion), la tension Veoc reprend sa valeur haute et la tension VCLKREF est remplacée par une tension VCLK délivrée par une horloge externe au moyen d'un circuit 770 (représente ci-après sur la figure 10) à base d'un inverseur 773, de deux portes ET 771 et d'une porte OU 772.

Ainsi, les commutations complémentaires des premier 762 et second 763 multiplexeurs sont utilisés conjointement avec les commutations de la sortie du premier comparateur 720 afin de générer les fronts montants et descendants de l'horloge de conversion VCLKREF.Ainsi, grâce à l'invention, la période et le rapport cyclique de cette horloge VCLKREF sont continument adaptés pendant la phase de conversion en fonction des temps d'établissement du CNA 710 et des temps de réponse d'une part du premier comparateur 720 et d'autre part du multiplexeur 761 et du deuxième comparateur 762.

Préférentiellement, les comparateurs 720 et 762 sont identiques, afin d'obtenir des temps de propagation très proches pour une différence de tension |Vin1-Vdac| donnée.

Selon un mode de réalisation préférentiel de l'invention, le temps de commutation du multiplexeur 761 est choisi aussi bref que possible, et est très inférieur au temps de réponse du comparateur.

On présente, en relation avec la ***figure 10**,* un schéma d'une implémentation particulière du convertisseur analogique / numérique a approximations successives 7000 selon le mode de réalisation particulier de l'invention.

Par soucis de clarté, seul un lien est représenté entre les dix sorties 736 du SAR 730 et les dix entrées 711 du CNA 710.

Sur cette figure 10 :
- il n'a pas été representé de temporisation 7635 ;
- on désigne la tension VCLKREF inversée par VCOMPREFB ;
- deux montages de type amplificateur suiveur 781 et 782 sont mis en oeuvre respectivement entre la première sortie 754 de l'échantillonneur bloqueur 750 et la première entrée 7611 du multiplexeur 761 et entre la seconde sortie 755 de l'échantillonneur bloqueur 750 et la seconde entrée 7612 du multiplexeur 761, afin d'isoler le circuit d'adaptation dynamique 760 de l'échantillonneur bloqueur 750 de façon à éviter que le bruit provenant la commutation des interrupteurs 7616 a 7619 ne perturbe l'échantillonneur bloqueur 750.

Dans la présente implémentation, deux inverseurs 791 et 792 jouant le rôle de buffers tampon sont mis en oeuvre en sortie de la porte OU exclusif 7634 afin de réduire les temps de montée et de descente de la tension VCOMPREF.

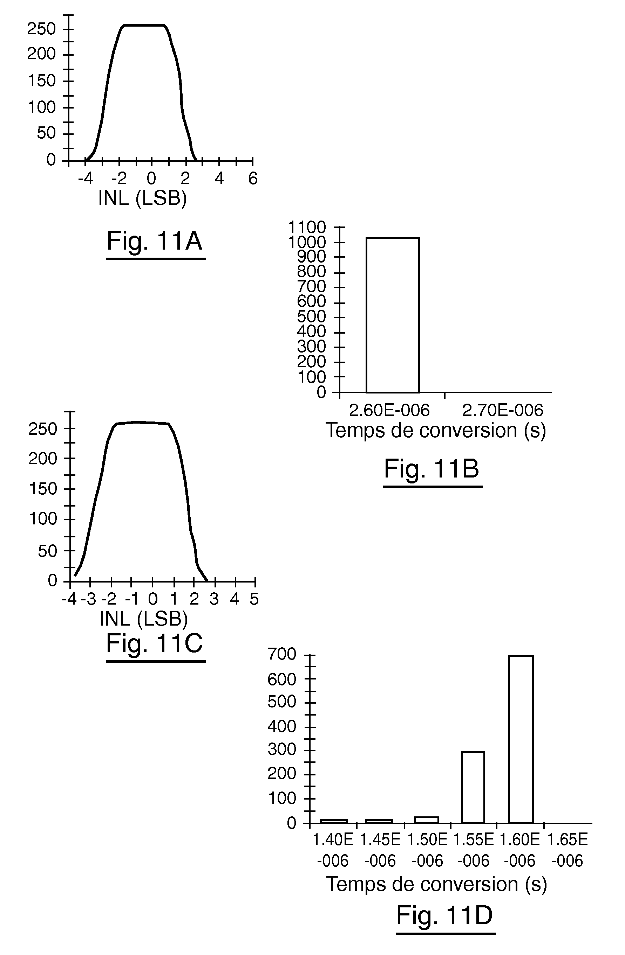

On présente, en relation avec les ***figures 11A a 11D**,* des diagrammes représentant la distribution de l'erreur (ou non linéarité intégrale, pour « Integral Non Linearity » ou INL) en LSB sur le codage de Vin et la distribution du temps de conversion (en s) du CAN à approximations successives 7000 dans le cas où une adaptation dynamique, conforme à l'invention, de la période de l'horloge de conversion est mise en oeuvre (figure 11C et 11D) et dans le cas classique où la période de l'horloge de conversion est constante (figure 11A et 11B).

Pour les diagrammes des figures 11A et 11C, l'abcisse représente l'erreur ou non linéarite intégrale en LSB et l'ordonnée représente le nombre de valeurs de la tension Vin (comprise entre de 0 et 1024) qui ont été codées avec une erreur donnée.

Pour les diagrammes des figures 11B et 11D, l'abcisse représente l'erreur ou non linéarite intégrale en LSB et l'ordonnée représente le nombre de valeurs de la tension Vin (comprise entre de 0 et 1024) qui ont été codées avec un temps de conversion donné.

On peut se rendre compte que la mise en oeuvre de l'adaptation dynamique, conforme a l'invention, de la période de l'horloge de conversion permet de :
- réduire la durée de la phase de conversion. La durée totale de la conversion variant de 1,4µS à 1,6µS en fonction de la tension d'entrée; la durée totale de conversion étant par ailleurs de 2,6µS avec la solution classique où la période de l'horloge de conversion est constante ;
- maintenir les erreurs de conversion inférieures ou égales à celles obtenues avec la solution classique où la période de l'horloge de conversion est constante. La non linéarité intégrale est la différence entre le code numérique obtenu d'une part à la sortie d'un CAN idéal et d'autre part à la sortie du convertisseur teste, soit avec une horloge à pas variable, conformément à l'invention, soit avec la solution classique où la période de l'horloge de conversion est constante.

Bien entendu, un circuit d'adaptation dynamique de la période de l'horloge de conversion selon l'invention peut être mis en oeuvre dans tout convertisseur analogique / numérique à approximations successives.

Par ailleurs, la pressente invention s'applique notamment à la fois aux architectures de CAN à approximations successives utilisant des capacités commutées et aux architectures de CAN à approximations successives utilisant des techniques linéaires.

On rappelle que les techniques linéaires utilisent des composants résistifs ou à base de générateurs de courant, ainsi que des amplificateurs.

Les techniques non linéaires utilisent des capacités commutées par une horloge de référence, afin d'émuler les composants résistifs et les sources de courant. L'avantage des systèmes à capacités commutées repose sur la précision des dispositifs qui dépend d'une horloge (qui peut être très précise) et de l'appariement (ou « matching ») des composants capacitifs (bien maîtrisé).

## Revendications

1. Convertisseur analogique / numérique à approximations successives (7000) comprenant un registre à approximations successives (730) alimentant un convertisseur numérique / analogique (710), des premiers moyens de comparaison (720) d'un signal d'entrée (Vin ; Vin1) du convertisseur analogique / numérique à un signal de sortie (Vdac) du convertisseur numérique / analogique délivrant un premier signal de comparaison (Vcomp33),
ledit convertisseur analogique / numérique à approximations successives étant synchronisé par un signal d'horloge provenant d'une horloge de conversion,
**caractérisé en ce qu'**il comprend des moyens (760) d'adaptation dynamique de la période de l'horloge de conversion en fonction d'au moins un paramètre,
et **en ce que** les moyens d'adaptation dynamique (760) de la période de l'horloge de conversion comprennent des moyens (761, 762, 763) de mesure d'au moins un temps de réponse des premiers moyens de comparaison (720) et/ou des moyens de mesure d'au moins un temps d'établissement d'au moins une tension analogique par le convertisseur numérique / analogique (710).

2. Convertisseur selon la revendication 1, **caractérisé en ce que** les moyens de mesure comprennent des seconds moyens (761, 762) de comparaison du signal d'entrée du convertisseur analogique / numérique au signal de sortie du convertisseur numérique / analogique délivrant un second signal de comparaison (Vnet145) alimentant des moyens de génération (763) de ladite horloge de conversion et **en ce que** les moyens de génération (763) de ladite horloge de conversion tiennent compte desdits premier (Vcomp33) et second (Vnet145) signaux de comparaison.

3. Convertisseur selon la revendication 2, **caractérisé en ce que** les moyens (761, 762, 763) de mesure sont adaptés à mesurer également au moins un temps de réponse des seconds moyens de comparaison (761, 762).

4. Convertisseur selon l'une quelconque des revendications 2 et 3, **caractérisé en ce que** les premiers moyens de comparaison comprennent un premier comparateur (720) **en ce que** les seconds moyens de comparaison comprennent un second comparateur (762) et **en ce que** les premier et second comparateurs sont identiques.

5. Convertisseur selon la revendication 4, **caractérisé en ce que** les seconds moyens de comparaison comprennent des moyens de multiplexage (761) du signal d'entrée (Vin) du convertisseur analogique / numérique et du signal de sortie (Vdac) du convertisseur numérique / analogique sur des première (7621) et seconde (7622) entrées du second comparateur tenant compte du signal d'horloge.

6. Convertisseur selon la revendication 5, **caractérisé en ce que** les moyens de multiplexage (761) comprennent au moins un interrupteur (7616, 7618) commandé par le signal d'horloge et au moins un interrupteur (7617, 7619) commandé par l'inverse du signal d'horloge.

7. Convertisseur selon l'une quelconque des revendications 2 à 6, **caractérisé en ce que** lesdits moyens de génération (763) de l'horloge de conversion comprennent au moins une porte OU exclusif (7634).

8. Convertisseur selon l'une quelconque des revendications 2 a 7, **caractérisé en ce que** lesdits moyens de génération de l'horloge de conversion comprennent des moyens de temporisation appliqués sur ledit signal d'horloge.

9. Convertisseur selon l'une quelconque des revendications 1 a 8, **caractérisé en ce que** les moyens (760) d'adaptation dynamique de la période de l'horloge de conversion comprennent des moyens d'isolation du convertisseur analogique / numérique d'un bruit généré par les moyens d'adaptation dynamique (760).

10. Convertisseur selon la revendication 9, **caractérise en ce que** lesdits moyens d'isolation comprennent au moins un montage amplificateur suiveur (781, 782).

11. Convertisseur selon l'une quelconque des revendications 1 a 10, **caractérisé en ce que** ledit au moins un paramètre appartient au groupe comprenant les :
- temps de réponse des premiers moyens de comparaison ;
- temps d'établissement d'au moins une tension analogique par le convertisseur numérique / analogique ;
- signal d'entrée du convertisseur analogique / numérique ;
- température de fonctionnement du convertisseur analogique / numérique ;
- process de fabrication du convertisseur analogique / numérique.

12. Composant intégré, **caractérisé en ce qu'**il comprend un convertisseur analogique / numérique à approximations successives (7000) selon l'une quelconque des revendications 1 a 11.

13. Procédé de conversion par approximations successives d'un signal analogique d'entrée en un signal numérique de sortie mis en oeuvre par un convertisseur analogique / numérique à approximations successives (7000) comprenant un registre à approximations successives (730) alimentant un convertisseur numérique / analogique (710), des premier moyens de comparaison (720) d'un signal d'entrée (Vin ; Vin1) du convertisseur analogique / numérique a un signal de sortie (Vdac) du convertisseur numérique / analogique délivrant un premier signal de comparaison (Vcomp33),
ladite conversion par approximations successives étant synchronisées par un signal d'horloge provenant d'une horloge de conversion,
**caractérisé en ce qu'**il comprend une étape d'adaptation dynamique de la période de l'horloge de conversion en fonction d'au moins un paramètre,
et **en ce que** l'étape d'adaptation dynamique de la période de l'horloge de conversion comprend une étape de mesure d'au moins un temps de réponse des premiers moyens de comparaison (720) et/ou une étape de mesure d'au moins un temps d'établissement d'au moins une tension analogique par le convertisseur numérique / analogique.
